# EUROPEAN PATENT APPLICATION

(11) **EP 3 573 243 A1**
(43) Date of publication of application: **27.11.2019**
(21) Application number: 19175495.1
(22) Date of filing: 20.05.2019
(51) Int. Cl.: H03M 11/00

(54) **INPUT DEVICE, CONTROL METHOD OF INPUT DEVICE**

(30) Priority: 24.05.2018 JP 2018099352
(71) Applicant: STANLEY ELECTRIC CO., LTD., Tokyo 153-8636 (JP)
(72) Inventor: TANAKA, Eriko, Tokyo, 153-8636 (JP); IDE, Yuki, Tokyo, 153-8636 (JP); ASAGA, Hisashi, Tokyo, 153-8636 (JP); FUJIMOTO, Kazuhiro, Tokyo, 153-8636 (JP)
(74) Representative: Emde, Eric

(57) **Abstract**

To achieve simplification of the circuit configuration and prevention of damage to the control part in an input device provided with a plurality of switches. An input device for inputting operation instructions including: two switches each having one end and the other end; and a control part having at least an input part and two input/output parts; where the input part is connected to the one end of each of the two switches; where the first input/output part is connected to the other end of the first switch; where the second input/output part is connected to the other end of the second switch; and where the control part switches the second input/output part to an input acceptance state when the control part outputs a scan signal from the first input/output part, and obtains a conductive state of the first switch by detecting the voltage generated at the input part.

## Description

### BACKGROUND OF THE INVENTION

### Field of the Invention

The present invention relates to an improved technique of an input device used for an operator to input an instruction to various electronic devices, etc.

### Description of the Background Art

A prior art of an input device used for an operator to input an instruction to various electronic devices, etc. is disclosed, in Japanese Unexamined Patent Application Publication No. 03-135298, for example. The remote control disclosed in this document is provided with membrane switches arranged in a matrix, and an instruction can be input by pressing one of the membrane switches.

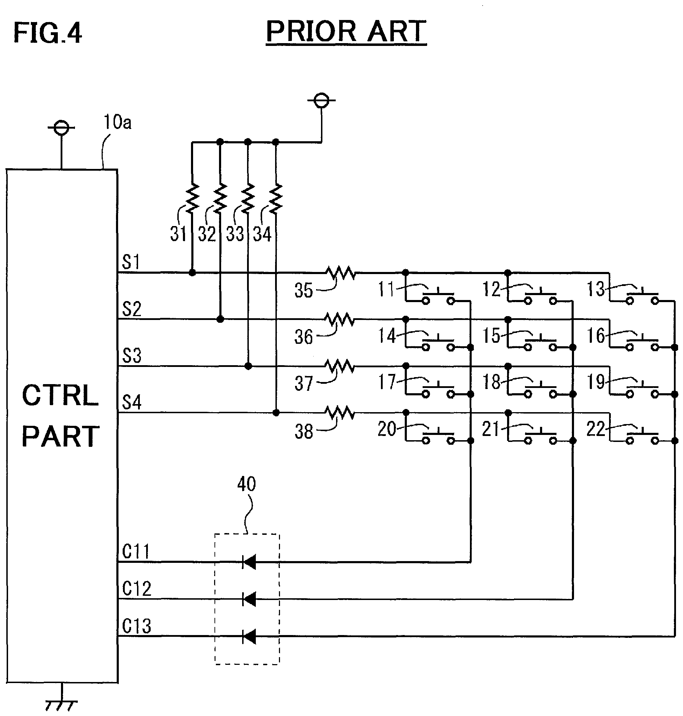

In FIG. 4, an example of a circuit configuration of the prior art input device provided with a plurality of switches as described above is shown. The input device shown in FIG. 4 is configured to include a control part 10a (abbreviated as CTRL PART in FIG. 4) comprising a microcomputer or the like, a plurality of switches 11 to 22 arranged in a matrix, resistance elements 31 to 38, and an element 40 for protection from reverse connection. In this input device, the control part 10a includes a plurality of output terminals C11, C12, and C13, and a plurality of input terminals S1, S2, S3, and S4. Each of the output terminals C11 to C13 is connected to one end of one of the switches 11 to 22, and each of the input terminals S1 to S4 is connected to the other end of one of the switches 11 to 22.

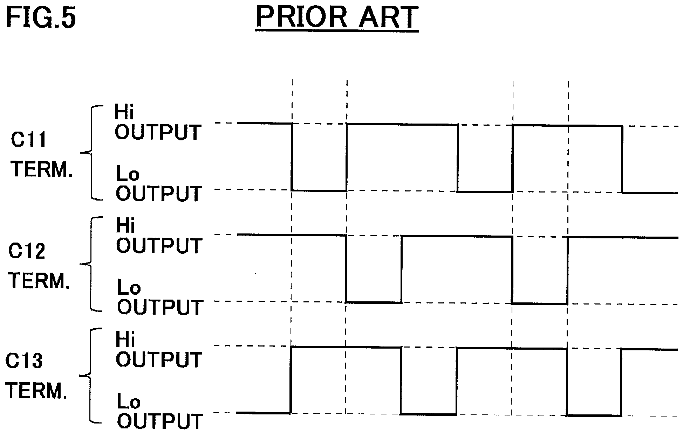

In FIG. 5, a timing chart of the prior art input device shown in FIG. 4 during its operation is illustrated. As illustrated, the input device sets each of the output terminals C11 to C13 (abbreviated as C11 TERM, C12 TERM, C13 TERM, respectively, in FIG. 5) to low potentials (Lo OUTPUT) at different timings, and correspondingly, the voltage is detected at each of the input terminals S1 to S4 to determine that each of the switches 11 to 22 is pressed. For example, when the switch 11 is pressed, at the timing when the potential of the C11 terminal becomes low as shown in FIG. 5, a current path passing through the resistance elements 31, 35, the switch 11, and the element 40 for protection from reverse connection is formed, thereby the low potential of the C11 terminal is detected at the input terminal S1 via the switch 11. Thus, the control part 10a is able to determine that the switch 11 has been pressed. Further, even when the switches 11 and 12 are simultaneously pressed, since the timing at which each of the potentials of the output terminals C11 and C12 becomes low is different, the control part 10a is able to determine that each of the switches 11 and 12 is pressed.

Here, in the prior art input device shown in FIG. 4, there may arise a demand for omitting the element 40 for protection from reverse connection for the purpose of cost reduction by reducing the number of parts and reducing the mounting area. However, if the element 40 for protection from reverse connection is simply omitted, when a plurality of switches are pressed simultaneously, the output terminals are short-circuited via those switches, and there is a possibility of damaging the microcomputer of the control part 10a.

For example, when the switches 11 and 12 are pressed simultaneously, during the period when the potential of the output terminal C11 is low (Lo OUTPUT) and the potential of the output terminal C12 is high (Hi OUTPUT), a wraparound current path is generated between the output terminal C11 and the output terminal C12 via the switches 11 and 12 and the wiring, thereby risking damage to the output terminal C11.

In a specific aspect, it is an object of the present invention to provide a technique which achieves both simplification of the circuit configuration and prevention of damage to the control part in an input device having a plurality of switches.

### SUMMARY OF THE INVENTION

[1] An input device according to one aspect of the present invention is a device for inputting operation instructions including: (a) at least two switches each having one end and the other end; and (b) a control part having at least an input part and at least two input/output parts; (c) where the input part is connected to the one end of each of the two switches; (d) where the first input/output part of the input/output parts is connected to the other end of the first switch of the two switches; (e) where the second input/output part of the input/output parts is connected to the other end of the second switch of the two switches; and (f) where the control part switches the second input/output part to an input acceptance state when the control part outputs a scan signal from the first input/output part, and obtains a conductive state of the first switch by detecting the magnitude of the voltage generated at the input part.
[2] A method according to one aspect of the present invention is a method having: (a) at least two switches each having one end and the other end in an input device; and (b) a control part having at least an input part and at least two input/output parts; (c) where the input part is connected to the one end of each of the two switches; (d) where the first input/output part of the input/output parts is connected to the other end of the first switch of the two switches; (e) where the second input/output part of the input/output parts is a method for detecting the conduction state of each of the two switches in the input device connected to the other end of the second switch of the two switches; and (f) where the control part switches the second input/output part to an input acceptance state when the control part outputs a scan signal from the first input/output part, and obtains a conductive state of the first switch by detecting the magnitude of the voltage generated at the input part.
[3] An electronic apparatus according to one aspect of the present invention is an electronic apparatus provided with the above described input device.

Here, the term "connected" referred to in this specification includes both (i) a case where specific circuit elements are directly connected to each other via a wiring or the like, and (ii) a case where another circuit element intervenes between the specific circuit elements, and the specific circuit elements are indirectly connected to each other.

According to the above configuration, it is possible to achieve both simplification of the circuit configuration and prevention of damage to the control part in an input device provided with a plurality of switches.

### BRIEF DESCRIPTION OF THE DRAWINGS

FIG. 1 is a diagram showing a circuit configuration of an input device according to one embodiment.
FIG. 2 is a circuit diagram showing an example of the configuration of the internal circuit of the input/output terminal in the control part of the input device.
FIG. 3 is a diagram showing a timing chart during the operation of the input device.
FIG. 4 is a diagram showing an example of a circuit configuration of the prior art input device provided with a plurality of switches.
FIG. 5 is a diagram showing a timing chart during the operation of the prior art input device shown in FIG 4.

### DESCRIPTION OF THE PREFERRED EMBODIMENTS

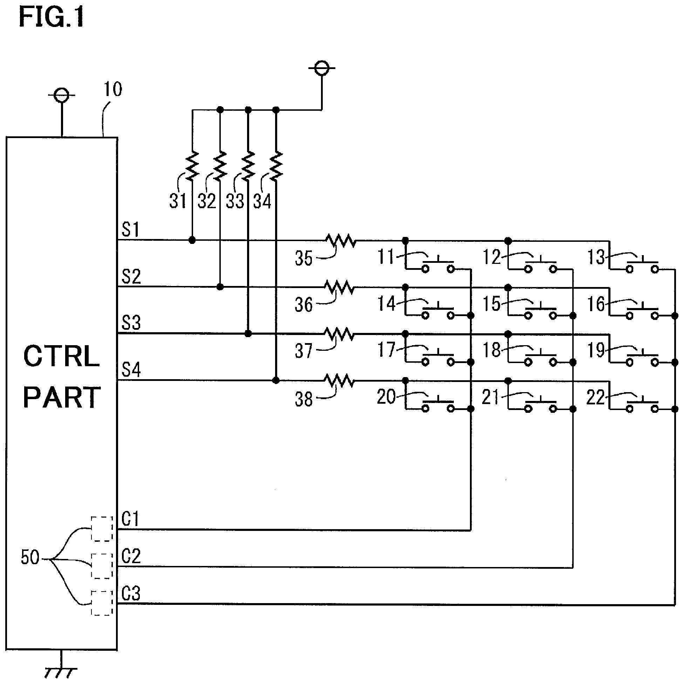

FIG. 1 is a diagram showing a circuit configuration of an input device according to one embodiment. The illustrated input device is configured to include a control part 10 (abbreviated as CTRL PART in FIG. 1) comprising a microcomputer or the like, a plurality of switches 11 to 22 arranged in a 4 × 3 matrix, and resistance elements 31 to 38. This input device detects whether or not each of the switches 11 to 22 has been pressed (that is, the detection of conductive state), and provides the detection result to a host device which is not shown in the figure. The host device described here may be various electronic devices such as an air conditioner, for example. The input device and the host device may be connected by wire or may be wirelessly connected.

The control part 10 has a plurality of input/output terminals C1, C2 and C3 and a plurality of input terminals S1, S2, S3 and S4. Each of the input/output terminals C1 to C3 is a terminal capable of selecting either an "output state" which is a state that outputs a low potential signal (scan signal) having a relatively low potential, or an "input state (input reception state)" which is a state that inputs (detects) an externally applied signal to the control part 10. The switching of each state can be realized by executing a predetermined program in the control part 10. Each of the input terminals S1 to S4 is a terminal for inputting (detecting) an externally applied signal to the control part 10.

The input terminal S1 of the control part 10 is connected to one end of each of the switches 11, 12, and 13 via a wire and the resistance element 35. Similarly, the input terminal S2 is connected to one end of each of the switches 14, 15, and 16 via a wire and the resistance element 36. Similarly, the input terminal S3 is connected to one end of each of the switches 17, 19, and 19 via a wire and the resistance element 37. Similarly, the input terminal S4 is connected to one end of each of the switches 20, 21, and 22 via a wire and the resistance element 38.

The input/output terminal C1 of the control part 10 is connected to the other end of each of the switches 11, 14, 17, and 20 via a wire. Similarly, the input/output terminal C2 is connected to the other end of each of the switches 12, 15, 18, and 21 via a wire. Similarly, the input/output terminal C3 is connected to the other end of each of the switches 13, 16, 19, and 22 via a wire.

One end of the resistance element 31 is connected to a power supply terminal (high potential terminal), and the other end is connected between the input terminal S1 and one end of the switch 11. One end of the resistance element 32 is connected to the power supply terminal, and the other end is connected between the input terminal S2 and one end of the switch 14. One end of the resistance element 33 is connected to the power supply terminal, and the other end is connected between the input terminal S3 and one end of the switch 17. One end of the resistance element 34 is connected to the power supply terminal, and the other end is connected between the input terminal S4 and one end of the switch 20.

The resistance element 35 is connected between the input terminal S1 and one end of the switch 11. The resistance element 36 is connected between the input terminal S2 and one end of the switch 14. The resistance element 37 is connected between the input terminal S3 and one end of the switch 17. The resistance element 38 is connected between the input terminal S4 and one end of the switch 20. These resistance elements 35 to 38 function as pull-up resistance elements.

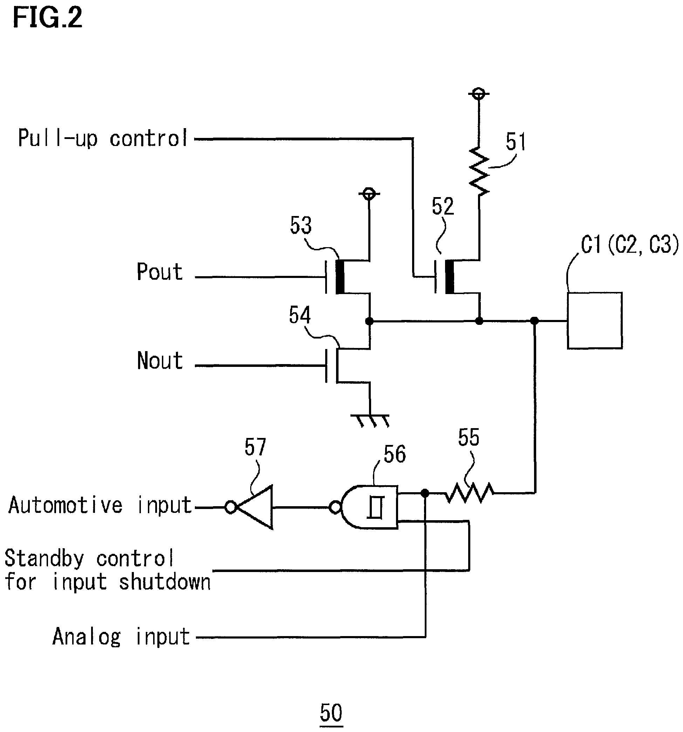

FIG. 2 is a circuit diagram showing an example of the configuration of the internal circuit of the input/output terminal in the control part of the input device. The illustrated input/output circuit 50 is a circuit for switching the input/output terminal C1 to either the "output state" or the "input state", and is configured to include resistance elements 51 and 55, transistors 52, 53 and 54, a NAND element (NAND circuit) 56, a NOT element (NOT circuit) 57. Although the description is omitted here, the same input/output circuit 50 is provided for the other input/output terminals C2 and C3.

One end of the resistance element 51 is connected to the power supply terminal (high potential terminal), and the other end is connected to the transistor 52. Also, the resistance element 55 is connected between the input end of the NAND element 56 and the input/output terminal C1.

The transistor 52 is a P-channel field effect transistor, for example, and one end of the current path (source/drain) is connected to the power supply terminal through the resistance element 51, and the other end of the current path (source/drain) is connected to the input/output terminal C1. A control signal (Pull-up control) is provided to the control end (gate) of the transistor 52 from an internal circuit of the control part 10 which is not shown in the figure.

The transistor 53 is a P-channel field effect transistor, for example, and one end of the current path (source/drain) is connected to the power supply terminal, and the other end of the current path (source/drain) is connected to the input/output terminal C1. A control signal (Pout) is provided to the control end (gate) of the transistor 53 from an internal circuit of the control part 10 which is not shown in the figure.

The transistor 54 is a N-channel field effect transistor, for example, and one end of the current path (source/drain) is connected to the reference potential terminal (ground terminal), and the other end of the current path (source/drain) is connected to the input/output terminal C1. A control signal (Nout) is provided to the control end (gate) of the transistor 54 from an internal circuit of the control part 10 which is not shown in the figure.

The first input end of the NAND element 56 is connected to the input/output terminal C1 via the resistance element 55, the second input end is connected to an internal circuit of the control part 10 which is not shown in the figure, and the output terminal is connected to the input end of NOT element 57. The second input end of the NAND element 56 receives a control signal (Standby control for input shutdown) from the internal circuit of the control part 10.

The input end of the NOT element 57 is connected to the output end of the NAND element 56. The signal (Automotive input) obtained from the output end of the NOT element 57 corresponds to the externally applied signal via the input/output terminal C1. Here, the circuit is arranged so that the externally applied signal (Analog input) can be directly obtained from the input/output terminal C1 via the resistance element 55.

The operation of this input/output circuit 50 will be described below. When the input/output terminal C1 is set to the "output state", the potential of the control signal (Pout, Nout) applied to the control end of each of the transistors 53, 54 is controlled. Thus, the high potential signal or the low potential signal can be selectively outputted from the input/output terminal C1. At this time, the control part 10 sets the control signal (Standby control for input shutdown) to a predetermined potential and provides it to the second input end of the NAND element 56. Thereby, the control part 10 acquires neither the signal obtained from the output end of the NOT element 57 (Automotive input) nor the signal (Analog input) obtained from the input/output terminal C1 via the resistance element 55.

On the other hand, when the input/output terminal C1 is set to the "input state", the control part 10 controls the potential of the control signals (Pout, Nout) applied to the control end of each of the transistors 53 and 54 so that the high potential signal or the low potential signal is not outputted, and then detects either the signal (Automotive input) obtained from the output end of the NOT element 57 or the signal (Analog input) obtained from the input/output terminal C1 via the resistance element 55. As described above, the input/output terminal C1 can be switched to the "output state" or the "input state". At this time, the input/output terminal C1 is in a high impedance state in which a voltage can be detected without substantial current flow. The same applies to the other input/output terminals C2 and C3.

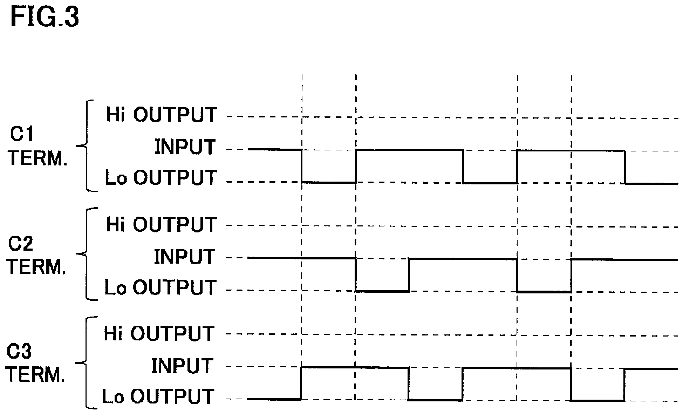

FIG. 3 is a diagram showing a timing chart during the operation of the input device. As shown in the figure, the control part 10 of the input device sets each of the potentials of the input/output terminals C1 to C3 (abbreviated as C1 TERM., C2 TERM., C3 TERM. respectively, in FIG. 3) to a low potential at different timings, and detects voltages at each of the input terminals S1 to S4 correspondingly, thereby determines whether or not the switches 11 to 22 have been pressed. For example, when the switch 11 is pressed, a current path passing through the resistance elements 31 and 35 and the switch 11 is formed at the timing when the input/output terminal C1 becomes low potential, and the low potential signal of the input/output terminal C1 (scan signal) is inputted to the input terminal S1 via the switch 11. As a result, the control part 10 can detect that the switch 11 has become conductive and can determine that the switch has been pressed. Similarly for the other switches 14, 17, and 20 connected to the input/output terminal C1, the conductive state (conductive/non-conductive) of each switch is detected through the input terminals S2, S3, and S4. The same applies to the other input/output terminals C2 and C3, and the conductive state of each switch is detected at the timing when each of the input/output terminals C2 and C3 has a low potential.

The control part 10 controls each of the input/output terminals C1 to C3 to the above-described "input state" in a period other than the period for outputting a low potential signal (the period of the above-described "output state"). That is, in the input device of the present embodiment, each input/output terminal C1 to C3 is controlled so that, while one input/output terminal (for example, the input/output terminal C1) is in the "output state", the other two input/output terminals (for example, the input/output terminals C2 and C3) are in the "input state". As a result, for example, even when the switches 11 and 12 are simultaneously pressed, a low potential signal is outputted from the input/output terminal C1, but since the input/output terminal is in the "input state", a wraparound current path does not occur between the input/output terminal C1 and the input/output terminal C2. The same applies to the other switches (for example, the switch 13), and even when a plurality of switches are pressed simultaneously, a wraparound current path does not occur. Therefore, even when the reverse connection preventing element is not provided, damages to the input/output terminals C1 to C3 of the control part 10 do not occur.

According to the embodiment as described above, it is possible to achieve both simplification of the circuit configuration and prevention of damage to the control part in an input device provided with a plurality of switches.

It should be noted that this invention is not limited to the subject matter of the foregoing embodiment, and can be implemented by being variously modified within the scope of the present invention as defined by the appended claims. For example, the number and the type of switches provided in the input device are not limited to those in the above embodiment. Further, the circuit configuration of the input device in the above-described embodiment is merely an example, and other circuit elements may be included as long as the intended operation is not impeded.

## Claims

1. An input device for inputting operation instructions comprising:
at least two switches each having one end and the other end; and
a control part having at least an input part and at least two input/output parts;
wherein the input part is connected to the one end of each of the two switches;
wherein the first input/output part of the input/output parts is connected to the other end of the first switch of the two switches;
wherein the second input/output part of the input/output parts is connected to the other end of the second switch of the two switches; and
wherein the control part switches the second input/output part to an input acceptance state when the control part outputs a scan signal from the first input/output part, and obtains a conductive state of the first switch by detecting the magnitude of the voltage generated at the input part.

2. The input device according to claim 1,
wherein the input acceptance state of the second input/output part is a high impedance state in which a voltage can be detected without substantial current flow.

3. The input device according to claim 1 or 2 further comprising:
a pull-up resistance element connected between one end of the first switch and the input part.

4. A method comprising:
at least two switches each having one end and the other end in an input device; and
a control part having at least an input part and at least two input/output parts;
wherein the input part is connected to the one end of each of the two switches;
wherein the first input/output part of the input/output parts is connected to the other end of the first switch of the two switches;
wherein the second input/output part of the input/output parts is a method for detecting the conduction state of each of the two switches in the input device connected to the other end of the second switch of the two switches;and
wherein the control part switches the second input/output part to an input acceptance state when the control part outputs a scan signal from the first input/output part, and obtains a conductive state of the first switch by detecting the magnitude of the voltage generated at the input part.

5. An electronic apparatus comprising the input device according to any one of claims 1 to 3.
